# EUROPEAN PATENT APPLICATION

(11) **EP 3 486 953 A1**
(43) Date of publication of application: **22.05.2019**
(21) Application number: 18188531.0
(22) Date of filing: 10.08.2018
(51) Int. Cl.: H01L 31/0224, H01L 31/0747

(54) **HETEROJUNCTION SOLAR CELL AND PREPARATION METHOD THEREOF**

(30) Priority: 15.11.2017 CN 201711132081; 06.08.2018 WO PCT/CN2018/099038
(71) Applicant: Beijing Juntai Innovation Technology Co., Ltd, 100176 Beijing (CN)
(72) Inventor: WANG, Jin, Beijing, Beijing 100176 (CN); PENG, Fuguo, Beijing, Beijing 100176 (CN); HU, Dezheng, Beijing, Beijing 100176 (CN); XU, Xixiang, Beijing, Beijing 100176 (CN); LI, Yuanmin, Beijing, Beijing 100176 (CN)
(74) Representative: D'Halleweyn, Nele Veerle Trees Gertrudis

(57) **Abstract**

A preparation method of a heterojunction solar cell is provided. The method includes the following steps of: sequentially forming an intrinsic layer, forming a doped silicon layer, forming a transparent conductive film layer, forming a metal thin layer and forming an electrode layer on at least one side of a crystalline silicon substrate. A heterojunction solar cell is also provided.

## Description

The present application claims priority to Chinese patent application number 201711132081.0 filed on November 15, 2017, the entire contents of which are incorporated herein by reference.

### Technical Field

The present application relates to, but is not limited to, the technical field of solar cells, in particular to, but is not limited to, a heterojunction solar cell and a preparation method thereof.

### Background

Heterojunction solar cells have the advantages of high efficiency, low temperature coefficient, no light induced degradation (LID) and potential induced degradation (PID) effects, double-sided power generation and large space for cost reduction, etc., they are considered as one of the high efficiency cells that can be produced in mass production in the next generation.

For the processing of heterojunction solar cells, the paste used for screen printing is low temperature silver paste because the process temperature requirement is lower than 200°C. But the welding tension of low temperature silver paste is relatively low, generally 1N/cm, or even lower. However, welding tension is very important to the preparation of components and the reliability of components in the later stage, the risk brought by low welding tension is that: first, cells cannot be made into components; second, even if components are made reluctantly, they may not pass the component reliability test.

The methods commonly used at present to improve the welding tension of low-temperature silver paste for heterojunction solar cells are as follows:
1. increasing the content of resin in low temperature silver paste, but the disadvantage of doing so is that the content of silver will decrease with it, resulting in an increase in the bulk resistance of the paste, and the filling factor of the cell will decrease after making the cell.
2. designing a screen printing plate with a larger size to increase the width of the main grid line, but the disadvantage of doing so is to increase the light shielding area, reduce the short circuit current of the cell, increase the dosage of the paste and increase the cost;
3. adjusting the design size of the screen-printing plate or adjusting the printing process to increase the height of the main grid line, but the disadvantage of doing so is increasing the amount of paste used, resulting in increased costs and possibly resulting in poor printing quality.

### Summary

The following is an overview of the subject matter described in detail herein. This summary is not intended to limit the protection scope of the claims.

Aiming at the problems in the prior art, the present application provides a heterojunction solar cell and a preparation method thereof, which increases the welding tension of a low-temperature silver paste main grid line and improves the yield and reliability of a solar photovoltaic module.

An embodiment of the present application provides a preparation method of a heterojunction solar cell, which includes the following steps of: sequentially forming an intrinsic layer, forming a doped silicon layer, forming a transparent conductive film layer, forming a metal thin layer, and forming an electrode layer on at least one side of a crystalline silicon substrate.

An embodiment of the present application provides a heterojunction solar cell, which includes an intrinsic layer, a doped silicon layer, a transparent conductive film layer, a metal thin layer and an electrode layer which are sequentially arranged on at least one side of a crystalline silicon substrate.

An embodiment of the present application provides a preparation method of a heterojunction solar cell, which includes the following steps of:
depositing a first intrinsic amorphous silicon layer on a front side of a crystalline silicon substrate, depositing a second intrinsic amorphous silicon layer on a back side of the crystalline silicon substrate; or depositing the first intrinsic amorphous silicon layer on the back side of the crystalline silicon substrate, depositing the second intrinsic amorphous silicon layer on the front side of the crystalline silicon substrate;
depositing a N-type amorphous silicon layer on the first intrinsic amorphous silicon layer, depositing a P-type amorphous silicon layer on the second intrinsic amorphous silicon layer;
depositing transparent conductive film layers on the surface of the N-type amorphous silicon layer and the surface of the P-type amorphous silicon layer respectively;
depositing silver thin layers on the two transparent conductive film layers respectively;
forming main grid line electrodes on the two silver thin layers respectively by screen printing.

An embodiment of the present application provides a heterojunction solar cell, which includes:
a crystalline silicon substrate;
intrinsic amorphous silicon layers disposed on a front side and back side of the crystalline silicon substrate;
a N-type amorphous silicon layer disposed on an intrinsic amorphous silicon layer on the front side of the crystalline silicon substrate;
a P-type amorphous silicon layer disposed on an intrinsic amorphous silicon layer on the back side of the crystalline silicon substrate;
transparent conductive film layers disposed on the N-type amorphous silicon layer and the P-type amorphous silicon layer;
silver thin layers disposed on the two transparent conductive film layers; and
main grid line electrodes disposed on the two silver thin layers.

### Brief Description of Drawings

The accompanying drawings are used to provide a further understanding of the technical solution of the present application and form a part of the specification, and together with the embodiments of the present application, serve to explain the technical solution of the present application and do not constitute a limitation on the technical solution of the present application.
FIG. 1 is a flowchart of a preparation method of a heterojunction solar cell provided in an embodiment of the present application;
FIG. 2 is a structural schematic diagram of a heterojunction solar cell provided in an embodiment of the present application.
FIG. 3 is a structural schematic diagram of a heterojunction solar cell provided in another embodiment of the present application.

In these drawings:
100--crystalline silicon substrate
200--intrinsic layer
300--N-type doped silicon layer
400--P-type doped silicon layer
500--transparent conductive film layer
600--silver thin layer
700--main grid line electrode

### Detailed Description

Embodiments of the present application are described in detail below with reference to the accompanying drawings, and examples of the embodiments are shown in the accompanying drawings, wherein the same or similar numerals denote the same or similar elements or elements having the same or similar functions. The embodiments described below with reference to the accompanying drawings are exemplary, and are only used to explain the present application but cannot be construed as limiting the present application.

An embodiment of the present application provides a preparation method of a heterojunction solar cell, which can include the following steps of: sequentially forming an intrinsic layer, forming a doped silicon layer, forming a transparent conductive film layer, forming a metal thin layer, and forming an electrode layer on at least one side of a crystalline silicon substrate.

In an exemplary embodiment, the metal thin layer may be selected from at least one of a silver thin layer, a silver aluminum thin layer, and a nickel vanadium thin layer.

In an exemplary embodiment, the thickness range value of the metal thin layer may be 10nm to 200nm.

In an exemplary embodiment, the transparent conductive film layer may be divided into a main grid region and a non-main grid region, and the metal thin layer is formed on the main grid region; the electrode layer may include a main grid line electrode formed on the metal thin layer.

In an exemplary embodiment, the electrode layer may further include a fine grid line electrode formed on the non-main grid region.

In an exemplary embodiment, the method may include the following steps of:
forming intrinsic layers on a front side and back side of the crystalline silicon substrate;
forming doped silicon layers on the intrinsic layers on the front side and back side of the crystalline silicon substrate;
forming transparent conductive film layers on the two doped silicon layers;
forming the metal thin layer on a transparent conductive film layer on at least one side of the crystalline silicon substrate;
forming the main grid line electrode on the metal thin layer; alternatively, forming the main grid line electrode on the metal thin layer, and forming the fine grid line electrode on the non-main grid region of the transparent conductive film layer where the metal thin layer is located; and
optionally, forming a metal layer or an electrode layer on a transparent conductive film layer that does not form a metal thin layer;
herein, doping types of the two doped silicon layers are different.

In an exemplary embodiment, the step of forming the metal thin layer on the transparent conductive film layer may include:
dividing the transparent conductive film layer into a main grid region and a non-main grid region;
shielding, by using a mask plate, the non-main grid region on the transparent conductive film layer and
depositing the metal thin layer on the main grid region on the transparent conductive film layer.

In an exemplary embodiment, the step of forming the metal thin layer on the transparent conductive film layer may include:
dividing the transparent conductive film layer into a main grid region and a non-main grid region;
coating photoresist on the transparent conductive film layer, exposing the main grid region on the transparent conductive film layer by a photoetching method; depositing the metal thin layer on the main grid region; removing photoresist of the non-main grid region on the transparent conductive film layer.

In an exemplary embodiment, when metal thin layers are formed on the transparent conductive film layers on the front side and back side of the crystalline silicon substrate, respectively, this step may include:
depositing a metal thin layer on a transparent conductive film layer on the front side of the crystalline silicon substrate, and then depositing a metal thin layer on a transparent conductive film layer on the back side of the crystalline silicon substrate;
alternatively, depositing a metal thin layer on a transparent conductive film layer on the back side of the crystalline silicon substrate, and then depositing a metal thin layer on a transparent conductive film layer on the front side of the crystalline silicon substrate;
alternatively, depositing the metal thin layers on the transparent conductive film layers on the front side and back side of the crystalline silicon substrate at the same time.

In an exemplary embodiment, the metal thin layer may be deposited using a physical vapor deposition method.

In an exemplary embodiment, the physical vapor deposition method may be a magnetron sputtering method where the sputtering power may be 1W/cm2 to 10W/cm2, the sputtering pressure may be 0.1Pa to 0.5Pa, and the sputtering gas may be argon.

In an exemplary embodiment, in the magnetron sputtering method, the sputtering power may be 2.5W/cm2, the sputtering pressure may be 0.2Pa, and the sputtering gas may be argon.

In an exemplary embodiment, the step of forming the main grid line electrode on the metal thin layer may include forming the main grid line electrode on the metal thin layer by screen printing.

In an exemplary embodiment, the step of forming the main grid line electrode of the electrode layer on the metal thin layer and forming the fine grid line electrode of the electrode layer on the non-main grid region of the transparent conductive film layer where the metal thin layer is located may include:
forming the fine grid line electrode of the electrode layer by screen printing on the non-main grid region of the transparent conductive film layer where the metal thin layer is located, after forming the main grid line electrode of the electrode layer on the metal thin layer;
alternatively, forming the main grid line electrode of the electrode layer on the metal thin layer, after forming the fine grid line electrode of the electrode layer by screen printing on a non-main grid region of the transparent conductive film layer where the metal thin layer is located;
alternatively, synchronously forming the fine grid line electrode of the electrode layer by screen printing on the non-main grid region of the transparent conductive film layer where the metal thin layer is located, when forming a main grid line electrode of the electrode layer on the metal thin layer.

In an exemplary embodiment, the metal layer may be selected from at least one of a silver layer, a silver aluminum layer, and a nickel vanadium layer.

In an exemplary embodiment, forming a metal layer on a transparent conductive film layer may be forming the metal layer on the entire surface of the transparent conductive film layer.

In an exemplary embodiment, the method may further include carrying out surface treatment on the crystalline silicon substrate by a texturing process, before forming intrinsic layers on the front side and back side of the crystalline silicon substrate; cleaning the crystalline silicon substrate after the texturing process.

In an exemplary embodiment, the method may further include: repairing the metal thin layer after forming a metal thin layer on a transparent conductive film layer on at least one side and before forming a main grid line electrode of the electrode layer on the metal thin layer.

In an exemplary embodiment, the step of repairing the metal thin layer may include repairing the metal thin layer by annealing.

In an exemplary embodiment, the step of repairing the metal thin layer may include repairing the metal thin layer by annealing of not more than 200°C.

In an exemplary embodiment, the intrinsic layer may be an intrinsic amorphous silicon layer.

In an exemplary embodiment, the doped silicon layer may be a N-type doped silicon layer or a P-type doped silicon layer, as long as the doping types of the doped silicon layers on the front side and back side of the crystalline silicon substrate are different, i.e., the doped silicon layer on one side is a N-type doped silicon layer and the doped silicon layer on the other side is a P-type doped silicon layer.

In an exemplary embodiment, the doped silicon layer may be an amorphous silicon doped silicon layer or a microcrystalline silicon doped layer.

An embodiment of the present application provides a heterojunction solar cell, which comprises an intrinsic layer, a doped silicon layer, a transparent conductive film layer, a metal thin layer and an electrode layer which are sequentially arranged on at least one side of a crystalline silicon substrate.

In an exemplary embodiment, the metal thin layer may be selected from at least one of a silver thin layer, a silver aluminum thin layer, and a nickel vanadium thin layer.

In an exemplary embodiment, the thickness range value of the metal thin layer may be 10nm to 200nm.

In an exemplary embodiment, the transparent conductive film layer may include a main grid region and a non-main grid region, the metal thin layer may be disposed on the main grid region; the electrode layer may include a main grid line electrode disposed on the metal thin layer.

In an exemplary embodiment, the number of the main grid line electrode may be 2 to 6.

In an exemplary embodiment, the electrode layer may further include a fine grid line electrode, which may be disposed on the non-main grid region.

In an exemplary embodiment, the range value of the diameter of the fine grid line electrode may be 20µm to 60µm.

In an exemplary embodiment, the heterojunction solar cell may include:
intrinsic layers disposed on a front side and back side of a crystalline silicon substrate;
doped silicon layers disposed on the intrinsic layers on the front side and back side of the crystalline silicon substrate;
transparent conductive film layers disposed on the two doped silicon layers; and
a metal thin layer disposed on a transparent conductive film layer on at least one side of the crystalline silicon substrate.

The main grid line electrode is disposed on the metal thin layer; alternatively, the main grid line electrode is disposed on the metal thin layer, and the fine grid line electrode is disposed on the non-main grid region of the transparent conductive film layer where the metal thin layer is located.

Optionally, the heterojunction solar cell may further include a metal layer or an electrode layer disposed on a transparent conductive film layer that is not provided with a metal thin layer;

The doping types of the two doped silicon layers are different.

In an exemplary embodiment, the metal layer may be selected from at least one of a silver layer, a silver aluminum layer, and a nickel vanadium layer.

In an exemplary embodiment, when the heterojunction solar cell further includes a metal layer disposed on a transparent conductive film layer that is not provided with a metal thin layer, the metal layer may be disposed on the entire surface of the transparent conductive film layer.

In an exemplary embodiment, the thickness range value of the crystalline silicon substrate may be 100µm to 250µm.

In an exemplary embodiment, the thickness range value of the intrinsic layer may be 1nm to 20nm.

In an exemplary embodiment, the thickness range value of the doped silicon layer may be 1nm to 20nm.

In an exemplary embodiment, the doped silicon layer may be an amorphous silicon doped silicon layer or a microcrystalline silicon doped layer.

In an exemplary embodiment, the thickness range value of the transparent conductive film layer may be 50nm to 150nm.

In an exemplary embodiment, the intrinsic layer may be an intrinsic amorphous silicon layer.

An embodiment of the present application provides a preparation method of a heterojunction solar cell, which comprises the following steps of:
depositing a first intrinsic amorphous silicon layer on a front side of a crystalline silicon substrate, depositing a second intrinsic amorphous silicon layer on a back side of the crystalline silicon substrate; or depositing the first intrinsic amorphous silicon layer on the back side of the crystalline silicon substrate, depositing the second intrinsic amorphous silicon layer on the front side of the crystalline silicon substrate;
depositing a N-type amorphous silicon layer on the first intrinsic amorphous silicon layer, depositing a P-type amorphous silicon layer on the second intrinsic amorphous silicon layer;
depositing transparent conductive film layers on a surface of the N-type amorphous silicon layer and a surface of the P-type amorphous silicon layer respectively;
depositing silver thin layers on the two transparent conductive film layer respectively;
forming main grid line electrodes on the two silver thin layers respectively by screen printing.

In an exemplary embodiment, the step of depositing silver thin layers on the two transparent conductive film layers respectively, may include:
shielding, by using mask plates respectively, non-main grid regions on the two transparent conductive film layers;
depositing the silver thin layers on the main grid region on the transparent conductive film layer.

In an exemplary embodiment, the method may further include forming fine grid line electrodes by screen printing on the non-main grid regions of the transparent conductive film layers on the front side and back side of the crystalline silicon substrate.

In an exemplary embodiment, the method may further include depositing a first intrinsic amorphous silicon layer on the front side of the crystalline silicon substrate, depositing a second intrinsic amorphous silicon layer on the back side of the crystalline silicon substrate; or depositing the first intrinsic amorphous silicon layer on the back side of the crystalline silicon substrate, carrying out surface treatment on the crystalline silicon substrate by a texturing process before depositing the second intrinsic amorphous silicon layer on the front side of the crystalline silicon substrate; cleaning the crystalline silicon substrate after the texturing process.

In an exemplary embodiment, the silver thin layer may be deposited by using a physical vapor deposition method.

In an exemplary embodiment, the silver thin layer may be deposited by a magnetron sputtering method where the sputtering power may be 2.5W/cm², the sputtering pressure may be 0.2Pa, and the sputtering gas may be argon.

In an exemplary embodiment, the method may further include: repairing the silver thin layers by low temperature thermal injection or low temperature light injection annealing, after depositing the silver thin layers on the transparent conductive film layer on the front side and back side of the crystalline silicon substrate, respectively.

An embodiment of the present application provides a heterojunction solar cell, which may include:
a crystalline silicon substrate;
intrinsic amorphous silicon layers disposed on a front side and back side of the crystalline silicon substrate;
a N-type amorphous silicon layer disposed on an intrinsic amorphous silicon layer on the front side of the crystalline silicon substrate;
a P-type amorphous silicon layer disposed on an intrinsic amorphous silicon layer on the back side of the crystalline silicon substrate;
transparent conductive film layers disposed on the N-type amorphous silicon layer and the P-type amorphous silicon layer;
silver thin layers disposed on the two transparent conductive film layer;
main grid line electrodes disposed on the two silver thin layers.

In an exemplary embodiment, the thickness range value of the silver thin layer may be 10nm to 200nm.

In an exemplary embodiment, the thickness range value of the crystalline silicon substrate may be 100µm to 250µm.

In an exemplary embodiment, the thickness range value of the intrinsic amorphous silicon layer may be 1nm to 20nm.

In an exemplary embodiment, the thickness range value of the N-type amorphous silicon layer may be 1nm to 20nm.

In an exemplary embodiment, the thickness range value of the P-type amorphous silicon layer may be 1nm to 20nm.

In an exemplary embodiment, the thickness range value of the transparent conductive film layer may be 50nm to 150nm.

In an exemplary embodiment, a fine grid line electrode may be provided on the transparent conductive film layer.

In an exemplary embodiment, the range value of the diameter of the fine grid line electrode may be 20µm to 60µm.

In an exemplary embodiment, the number of the main grid line electrode may be 2 to 6.

According to the heterojunction solar cell and the preparation method thereof provided by the embodiments of the present application, the metal thin layer is deposited between the transparent conductive film layer and the main grid line electrode. The main grid line electrode is solidified with the metal thin layer together through the action of the resin in the metal paste. Accordingly, the welding tension of the main grid line electrode is enhanced, and the reliability of the solar photovoltaic module is improved.

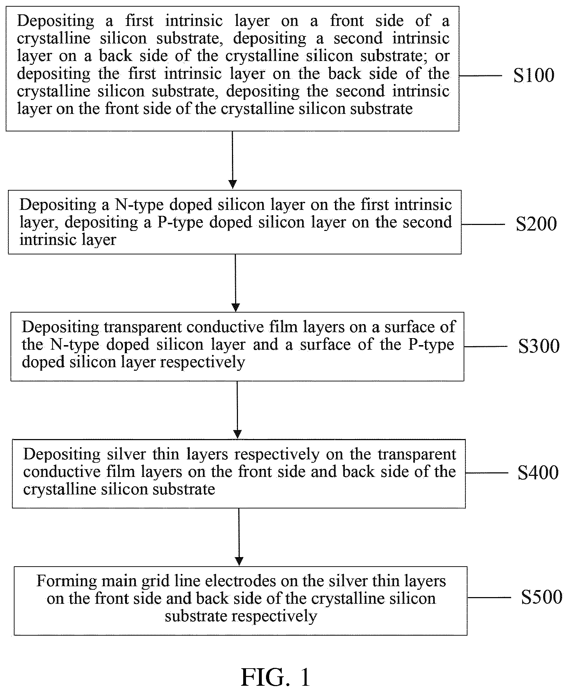

As shown in FIG. 1, an embodiment of the present application provides a preparation method of a heterojunction solar cell, which comprises the following steps of:
S100: Depositing a first intrinsic layer on a front side of a crystalline silicon substrate, depositing a second intrinsic layer on a back side of the crystalline silicon substrate; or depositing the first intrinsic layer on the back side of the crystalline silicon substrate, depositing the second intrinsic layer on the front side of the crystalline silicon substrate.

In an exemplary embodiment, a plasma enhanced chemical vapor deposition (PECVD) technique may be used to deposit a first intrinsic layer and a second intrinsic layer on the front side and back side of the crystalline silicon substrate, respectively. The thickness range value of the crystalline silicon substrate may be 100µm to 250µm, for example, the thickness value of the crystalline silicon substrate may be 120µm, 140µm, 160µm, 180µm, 200µm, 220µm, or 240µm. The thickness range value of the first intrinsic layer may be 1nm to 20nm, for example, the thickness value of the first intrinsic layer may be 4nm, 8nm, 12nm, 15nm, or 18nm. The thickness range value of the second intrinsic layer may also be 1nm to 20nm, for example, the thickness value of the second intrinsic layer may be 4nm, 8nm, 12nm, 15nm, or 18nm. A thicker intrinsic layer may increase the series resistance of solar cells and simultaneously hinder the transmission of sunlight, resulting in the deterioration of short-circuit current and overall efficiency; while a thinner intrinsic layer may weaken the built-in electric field and lead to the deterioration of the open circuit voltage. Therefore, the thickness of the intrinsic layer may be appropriately controlled. In the exemplary embodiment, the thickness value of the first intrinsic layer may be 12nm, and the thickness value of the second intrinsic layer may be 12nm. The intrinsic layer of this thickness is more beneficial to improving various performances of the heterojunction solar cell than the intrinsic layer of other thickness.

In an exemplary embodiment, the first intrinsic layer may be an intrinsic amorphous silicon layer and the second intrinsic layer may be an intrinsic amorphous silicon layer.

S200: Depositing a N-type doped silicon layer on the first intrinsic layer, depositing a P-type doped silicon layer on the second intrinsic layer.

In an exemplary embodiment, a PECVD technique may be used to deposit a N-type doped silicon layer on the first intrinsic layer and a P-type doped silicon layer on the second intrinsic layer. The thickness range value of the N-type doped silicon layer may be 1nm to 20nm, for example, the thickness value of the N-type doped silicon layer may be 4nm, 6nm, 8nm, 10nm, 12nm, 15nm, 18nm. The thickness range value of the P-type doped silicon layer may also be 1nm to 20nm, for example, the thickness value of the P-type doped silicon layer may be 4nm, 6nm, 8nm, 10nm, 12nm, 15nm, 18nm. If the thickness of the N-type doped silicon layer is too large, it may increase the series resistance of the solar cell and simultaneously hinder the transmission of sunlight, resulting in the deterioration of short-circuit current and overall efficiency. If the thickness of the N-type doped silicon layer is too small, it may not be able to form a built-in electric field with sufficient strength, resulting in the deterioration of the open circuit voltage. In an exemplary embodiment, the thickness value of the N-type doped silicon layer may be 10nm, and the thickness value of the P-type doped silicon layer may be 10nm.

In an exemplary embodiment, the N-type doped silicon layer may be an N-type amorphous silicon doped silicon layer, and the P-type doped silicon layer may be a P-type amorphous silicon doped silicon layer.

S300: Depositing transparent conductive film layers on a surface of the N-type doped silicon layer and a surface of the P-type doped silicon layer respectively. For example, transparent conductive film layers are plated respectively on the surface of the N-type doped silicon layer and the surface of the P-type doped silicon layer by using a magnetron sputtering technique. The thickness range value of the transparent conductive film layer may be 50nm to 150nm, for example, the thickness value of the transparent conductive film layer may be 60nm, 80nm, 100nm, 120nm, 140 nm.

S400: Depositing silver thin layers respectively on the transparent conductive film layers on the front side and back side of the crystalline silicon substrate. A silver thin layer can be deposited on one side of the crystalline silicon substrate first, then a silver thin layer can be deposited on the other side of the crystalline silicon substrate. Or, silver thin layers can be deposited on the front side and back side of the crystalline silicon substrate at the same time. The silver thin layer may be deposited by using a physical vapor deposition (PVD) process, for example, the silver thin layer may be deposited by using a magnetron sputtering method in a PVD process. In the magnetron sputtering method, the sputtering power may be 1W/cm² to 10W/cm², the sputtering pressure may be 0.1Pa to 0.5Pa, and the sputtering gas may be argon. In an exemplary embodiment, the sputtering power may be 2.5W/cm², the sputtering pressure may be 0.2Pa, and the sputtering gas may be argon of high purity, thereby realizing high-speed deposition of the silver thin layer at a lower temperature.

The sputtered material may be a pure silver metal target with a purity of 4N to 5N.

Slight interfacial plasma damage may be caused during sputtering of the silver thin layer. In order to repair the damage, after step S400, the method may further include:
S410: Repairing the silver thin layers by using low temperature thermal injection or low temperature light injection annealing.

In order to avoid damage to the solar cell material caused by excessively high temperature during annealing, in an exemplary embodiment, the annealing temperature does not exceed 200°C, and may be 150°C.

The thickness range value of the silver thin layer may be 10nm to 200nm, for example, the thickness value of the silver thin layer may be 30nm, 50nm, 70nm, 90nm, 1 10nm, 130nm, 150nm, 190nm. In an exemplary embodiment, in order to enable the silver thin layer to have higher welding strength after being combined with the main grid line electrode without affecting the performance of the heterojunction solar cell, the thickness value of the silver thin layer may be 110nm. In addition, the transparent conductive film layer may be metal oxide and the silver thin layer may be pure metal. As a result, the contact resistance generated at the interface of the silver thin layer after being deposited on the transparent conductive film layer can be neglected.

S500: Forming main grid line electrodes on the silver thin layers on the front side and back side of the crystalline silicon substrate respectively. For example, the main grid line electrode may be formed by screen printing.

In an exemplary embodiment, after step S500, the method may further include:
S600: Forming fine grid line electrodes on non-main grid regions on the transparent conductive film layers on the front side and back side of the crystalline silicon substrate. For example, the fine grid line electrodes may be formed by screen printing.

In the exemplary embodiment, step S600 may be performed first followed by step S500, or steps S500 and S600 may be performed simultaneously.

The silver thin layer may have a certain porosity. During screen printing process, the resin in the silver paste will penetrate into the silver thin layer to solidify the silver thin layer and the main grid line electrode into a whole, thus increasing the welding tension of the main grid line electrode. The silver thin layer has better electric conductivity and do not generate adverse physical or chemical reactions with the silver paste or the transparent conductive film layer. The fine grid line electrode is conductively connected with the main grid line electrode, the fine grid line electrode is used for collecting electrons or holes generated by light excitation and transmitting the collected electrons or holes to the main grid line electrode.

Step S400 may include:
S401: Shielding the non-main grid regions on the transparent conductive film layers on the front side and back side of the crystalline silicon substrate respectively by using mask plates. This step enables a silver thin layer to be uniformly deposited on the main grid region so as to ensure that the silver thin layer and the main grid line electrode are solidified into a whole when forming the main grid line electrode by screen printing.

Before depositing a silver thin layer on the transparent conductive film layer, a mask plate can be used to shield the non-main grid region so that the silver thin layer is uniformly deposited on the main grid region. After the silver thin layer deposition is completed, the mask plate is removed, and then the main grid line electrode is deposited by a screen printing process.

S402: Depositing silver thin layers on the main grid regions on the transparent conductive film layers.

Alternatively, step S400 may include:
S401': Respectively coating the photoresist on the transparent conductive film layers on the front side and back side of the crystalline silicon substrate and exposing main grid regions on the transparent conductive film layers by a photoetching method.
S402': Depositing the silver thin layers on the main grid regions.
S403': Removing the photoresist of non-main grid regions on the transparent conductive film layers. The method may further include: prior to step S100,
S10: Carrying out surface treatment on the crystalline silicon substrate by a texturing process.

It can be understood that the incident light can be reflected on the surface of the crystalline silicon substrate, and the sunlight irradiated on the surface of the solar cell cannot be fully utilized, therefore, the light trapping structure may be important for the heterojunction solar cell, the crystalline silicon substrate after the texturing process can form a random pyramid structure on its surface, thus improving the utilization rate of sunlight.

S20: Cleaning the crystalline silicon substrate after the texturing process to remove particles and metal contamination on the surface of the crystalline silicon substrate.

The silver thin layer is deposited between the transparent conductive film layer and the main grid line electrode. The main grid line electrode is solidified with the silver thin layer together through the action of the resin in the silver paste. Accordingly, the welding tension of the main grid line electrode is enhanced and the reliability of the solar photovoltaic module is improved.

In other embodiments provided by the present application, other metal thin layer may be used instead of the silver thin layer, for example, at least one of the silver aluminum thin layer and the nickel vanadium thin layer, and a composite thin layer of the silver thin layer and at least one of the silver aluminum thin layer and the nickel vanadium thin layer may be used. In this case, the welding tension of the main grid line electrode can also be increased, and the reliability of the solar photovoltaic module can be improved.

In an exemplary embodiment, the thickness range value of the metal thin layer may be 10nm to 200nm.

In other embodiments provided by the present application, a metal thin layer may be deposited on the transparent conductive film layer on only one side of the crystalline silicon substrate, i.e., depositing a metal thin layer on the transparent conductive film layer on the front side or back side of the crystalline silicon substrate. In this case, the welding tension of the main grid line electrode can also be increased, and the reliability of the solar photovoltaic module can be improved.

When a metal thin layer is only deposited on the transparent conductive film layer on the front side of the crystalline silicon substrate, the main grid line electrode as an electrode layer or an electrode layer composed of the main grid line electrode and the fine grid line electrode can be directly formed on the transparent conductive film layer on the back side of the crystalline silicon substrate. As a result, a double-sided heterojunction solar cell is obtained. Or, a metal layer may be deposited on the entire surface of the transparent conductive film layer on the back side of the crystalline silicon substrate, consequently a single-sided heterojunction solar cell is obtained. The metal layer may be selected from at least one of a silver layer, a silver aluminum layer, and a nickel vanadium layer.

When a metal thin layer is only deposited on the transparent conductive film layer on the back side of the crystalline silicon substrate, the main grid line electrode as an electrode layer or an electrode layer composed of the main grid line electrode and the fine grid line electrode can be directly formed on the transparent conductive film layer on the front side of the crystalline silicon substrate. As a result, a double-sided heterojunction solar cell is obtained.

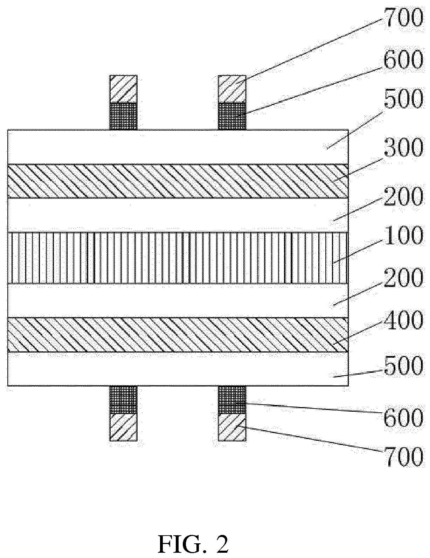

As shown in FIG. 2, an embodiment of the present application provides a heterojunction solar cell which can be obtained by adopting the preparation method of the heterojunction solar cell provided by any embodiment of the present application. The heterojunction solar cell comprises a crystalline silicon substrate 100, intrinsic layers 200 arranged on the front side and back side of the crystalline silicon substrate 100, a N-type doped silicon layer 300 arranged on the intrinsic layer 200 on the front side of the crystalline silicon substrate 100, a P-type doped silicon layer 400 arranged on the intrinsic layer 200 on the back side of the crystalline silicon substrate 100, transparent conductive film layers 500 arranged on the N-type doped silicon layer 300 and the P-type doped silicon layer 400, silver thin layers 600 arranged on the transparent conductive film layers 500 on the front side and back side of the crystalline silicon substrate 100, and main grid line electrodes 700 arranged on the silver thin layers 600 on the front side and back side of the crystalline silicon substrate 100.

The transparent conductive film layer may be indium tin oxide (ITO), aluminum doped zinc oxide (AZO), or the like; the intrinsic layer may be an intrinsic amorphous silicon layer; the N-type doped silicon layer may be a N-type amorphous silicon doped silicon layer, and the P-type doped silicon layer may be a P-type amorphous silicon doped silicon layer.

Among them, a silver thin layer 600 is deposited between the transparent conductive film layer 500 and the main grid line electrode 700. During the process of forming the main grid line electrode 700 by screen printing, the main grid line electrode 700 and the silver thin layer 600 can be solidified together because the silver thin layer is pure metal and the material of the main grid line electrode is mainly silver. After the main grid line electrode is formed by screen printing, the silver grid line electrode formed by screen printing is dried through a drying process. The general drying process is to place the cell sheet after screen printing in a drying furnace and use the hot air of the drying furnace to make the silver grid line electrode be dried and solidified on the cell sheet. The solvent added to the silver paste of the screen printing increases the flowability of the silver paste. During the drying process, the solver is evaporated, and the resin in the silver paste generates crosslinking. This enable the solidification effect of the main grid line electrode and the silver thin layer be better, the ohmic contact of the main grid line and the cell sheet be better, the resistance be smaller, thus increasing the output power of the cell sheet.

The material of the transparent conductive film layer may be metal oxide, while the silver thin layer is pure metal. When the silver thin layer is arranged on the transparent conductive film layer, the welding bonding force between the silver thin layer and the transparent conductive film layer is larger, and the ohmic contact between the silver thin layer and the transparent conductive film layer is better, the contact resistance is smaller, even can be negligible.

Accordingly, the welding tension of the main grid line electrode 700 is enhanced and the reliability of the solar photovoltaic module is enhanced.

The thickness range value of the silver thin layer 600 may be 10nm to 200nm, for example, the thickness value of the silver thin layer 600 may be 30nm, 50nm, 70nm, 90nm, 1 10nm, 130nm, 150nm, 190nm. In order to make the silver thin layer 600 have higher welding strength after being combined with the main grid line electrode 700 without affecting the performance of the heterojunction solar cell, in an exemplary embodiment, the thickness value of the silver thin layer 600 may be 110nm.

The thickness range value of the crystalline silicon substrate 100 may be 100µm to 250µm, for example, the thickness value of the crystalline silicon substrate 100 may be 120µm, 140µm, 160µm, 180µm, 200µm, 220µm, 240µm.

The thickness value of the intrinsic layer 200 may be 1nm to 20nm; for example, the thickness value of the intrinsic layer 200 may be 4nm, 8nm, 12nm, 15nm, 18nm. The thicker intrinsic layer 200 may lead to an increase in the series resistance of the solar cell while hindering the transmission of sunlight, resulting in a deterioration in the short-circuit current and the overall efficiency. The thinner intrinsic layer 200 may weaken the built-in electric field, resulting in the deterioration of the open circuit voltage. Therefore, the thickness of the intrinsic layer 200 can be appropriately controlled. In an exemplary embodiment, the thickness of the intrinsic layer 200 may be 12nm, the intrinsic layer 200 of this thickness is more beneficial to improving various performances of the heterojunction solar cell than the intrinsic layer 200 of other thickness.

The thickness range value of the N-type doped silicon layer 300 may be 1nm to 20nm; for example, the thickness value of the N-type doped silicon layer 300 may be 4nm, 6nm, 8nm, 10nm, 12nm, 15nm, 18nm. If the thickness of the N-type doped silicon layer 300 is too large, it may lead to an increase in the series resistance of the solar cell and simultaneously hinder the transmission of sunlight, resulting in the deterioration of short-circuit current and overall efficiency. If the thickness of the N-type doped silicon layer 300 is too small, it may not be able to form a built-in electric field with sufficient strength, resulting in the deterioration of the open circuit voltage. Therefore, in an exemplary embodiment, the thickness value of the N-type doped silicon layer 300 may be 10nm.

The thickness range value of the P-type doped silicon layer 400 may be 1nm to 20nm, the thickness value of the P-type doped silicon layer 400 may be 4nm, 6nm, 8nm, 10nm, 12nm, 15nm, 18nm, in order to ensure the light transmittance of sunlight and to form a built-in electric field with sufficient strength, the thickness value of the P-type doped silicon layer 400 may be 10nm.

The thickness range value of the transparent conductive film layer 500 may be 50nm to 150nm, for example, the thickness value of the transparent conductive film layer 500 may be 60nm, 80nm, 100nm, 120nm, 140nm.

The transparent conductive film layer 500 may be provided with fine grid line electrode for collecting electrons or holes generated by light excitation and transmitting the collected electrons or holes to the main grid line electrode. There may be a plurality of fine grid line electrodes, and a plurality of fine grid line electrodes are uniformly and more densely distributed on the transparent conductive film layer 500. The diameter range value of the fine grid line electrode may be 20µm to 60µm. In an exemplary embodiment, the diameter of the fine grid line electrode may be 35µm. In order to increase the distribution density of the fine gate line electrode and ensure the connection strength between the fine grid line electrode and the transparent conductive film layer 500, the output current may be increased.

The fine grid line electrode is conductively connected with the main grid line electrode, and the number of the main grid line electrode may be 2 to 6. In order to avoid waste of silver paste and enhance the bonding strength between the main grid line electrode and the fine grid line electrode, the number of the main grid line electrode may be 4. In other embodiments provided by the present application, the silver thin layer 600 may be provided only on the transparent conductive film layer 500 on the front side or back side of the crystalline silicon substrate 100, and the silver thin layer 600 is provided with the main grid line electrode 700.

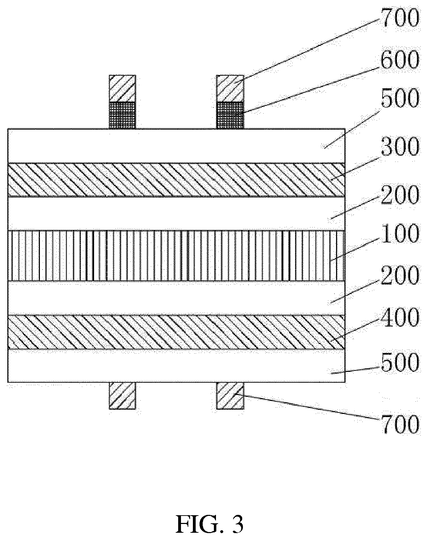

When the silver thin layer 600 is only arranged on the transparent conductive film layer 500 on the front side of the crystalline silicon substrate 100, the transparent conductive film layer 500 on the back side of the crystalline silicon substrate 100 can be directly provided with a main grid line electrode as an electrode layer or can be provided with an electrode layer composed of a main grid line electrode and a fine grid line electrode. As a result, a double-sided heterojunction solar cell is obtained and its structure is shown in FIG. 3. Or, a metal layer may be provided on the entire transparent conductive film layer 500 on the back side of the crystalline silicon substrate 100. As a result, a single-sided heterojunction solar cell is obtained. The metal layer may be selected from at least one of a silver layer, a silver aluminum layer, and a nickel vanadium layer.

When the silver thin layer 600 is only disposed on the transparent conductive film layer 500 on the back side of the crystalline silicon substrate 100, the main grid line electrode as an electrode layer or an electrode layer composed of the main grid line electrode and the fine grid line electrode can be directly disposed on the transparent conductive film layer 500 on the front side of the crystalline silicon substrate 100. As a result, a double-sided heterojunction solar cell is obtained.

In other embodiments provided by the present application, other metal thin layer may be used instead of the silver thin layer, for example, at least one of the silver aluminum thin layer and the nickel vanadium thin layer, and a composite thin layer of the silver thin layer and at least one of the silver aluminum thin layer and the nickel vanadium thin layer may be used. In this case, the welding tension of the main grid line electrode can also be increased, and the reliability of the solar photovoltaic module can be improved.

In an exemplary embodiment, the thickness range value of the metal thin layer may be 10nm to 200nm.

According to the heterojunction solar cell and the preparation method thereof provided by the embodiments of the present application, the metal thin layer is deposited between the transparent conductive film layer and the main grid line electrode. The main grid line electrode is solidified with the metal thin layer together through the action of the resin in the metal paste. Accordingly, the welding tension of the main grid line electrode is enhanced, and the reliability of the solar photovoltaic module is improved.

After testing, the setting of the metal thin layer can double the welding tension of the main grid line electrode. According to the international standard IEC61215, DH(double 85) test and TC(cold and hot cycle) test are carried out on the heterojunction solar cell of the embodiment of the present application, and the measured power loss of the module is reduced by 50%.

This disclosure is illustrative of the principles of examples of the present application and is not intended to limit the application in any form or substance, or to limit the application to particular embodiments. It will be apparent to those skilled in the art that variations, changes, modifications, variations, and the like may be made to the elements, methods, and systems of the technical solutions of the examples of the present application without departing from the principles, spirit, and scope of the examples, technical solutions of the present application. Embodiments of such variations, changes, modifications, and variations are all included within equivalent examples of the present application. Although the examples of the present application may be embodied in many different forms, what is described in detail herein are merely some embodiments of the present application. Furthermore, examples of the present application include any possible combination of some or all of the various embodiments described herein. All patents, patent applications, and other cited materials mentioned in this application or anywhere in any cited patent, cited patent application, or other cited material are hereby incorporated by reference in their entirety.

The above disclosure is intended to be illustrative and not exhaustive. Many variations and alternatives will be suggested to those skilled in the art. The term "including" means "including, but not limited to".

A description of alternative exemplary embodiments of the present application has been completed herein.

## Claims

1. A preparation method of a heterojunction solar cell, the method comprising the following steps of: sequentially forming an intrinsic layer, forming a doped silicon layer, forming a transparent conductive film layer, forming a metal thin layer, and forming an electrode layer on at least one side of a crystalline silicon substrate.

2. The preparation method according to claim 1, wherein the metal thin layer is selected from at least one of a silver thin layer, a silver aluminum thin layer, and a nickel vanadium thin layer.

3. The preparation method according to claim 1 or 2, wherein the transparent conductive film layer is divided into a main grid region and a non-main grid region, and the metal thin layer is formed on the main grid region; the electrode layer comprises a main grid line electrode, and the main grid line electrode is formed on the metal thin layer;
optionally, the electrode layer further comprises a fine grid line electrode, and the fine grid line electrode is formed on the non-main grid region.

4. The preparation method according to claim 3, wherein the method comprises the steps of:
forming intrinsic layers on a front side and back side of the crystalline silicon substrate;
forming doped silicon layers on the intrinsic layers on the front side and back side of the crystalline silicon substrate;
forming transparent conductive film layers on the two doped silicon layers;
forming the metal thin layer on a transparent conductive film layer on at least one side of the crystalline silicon substrate;
forming the main grid line electrode on the metal thin layer; alternatively, forming the main grid line electrode on the metal thin layer, and forming the fine grid line electrode on the non-main grid region of the transparent conductive film layer where the metal thin layer is located; and
optionally, forming a metal layer or an electrode layer on a transparent conductive film layer that does not form the metal thin layer;
wherein doping types of the two doped silicon layers are different.

5. The preparation method according to claims 1 to 4, wherein the metal thin layer is formed by using a physical vapor deposition method; optionally, the physical vapor deposition method is a magnetron sputtering method wherein sputtering power is 1W/cm² to 10W/cm², the sputtering pressure is 0.1Pa to 0.5Pa, and the sputtering gas is argon.

6. The preparation method according to claim 4, wherein forming the metal layer on the transparent conductive film layer is to form the metal layer on the entire surface of the transparent conductive film layer.

7. A heterojunction solar cell, comprising: an intrinsic layer, a doped silicon layer, a transparent conductive film layer, a metal thin layer, and an electrode layer sequentially disposed on at least one side of a crystalline silicon substrate.

8. The heterojunction solar cell according to claim 7, wherein the metal thin layer is selected from at least one of a silver thin layer, a silver aluminum thin layer, and a nickel vanadium thin layer; optionally, the thickness range value of the metal thin layer is 10nm to 200nm.

9. The heterojunction solar cell according to claim 7 or 8, wherein the transparent conductive film layer comprises a main grid region and a non-main grid region, the metal thin layer is disposed on the main grid region; the electrode layer comprises a main grid line electrode, and the main grid line electrode is arranged on the metal thin layer;
optionally, the electrode layer further includes a fine grid line electrode disposed on the non-main grid region.

10. The heterojunction solar cell according to claim 9, wherein the heterojunction solar cell comprises:
intrinsic layers disposed on a front side and back side of the crystalline silicon substrate;
doped silicon layers disposed on the intrinsic layers on the front side and back side of the crystalline silicon substrate;
transparent conductive film layers disposed on the two doped silicon layers; and
a metal thin layer disposed on a transparent conductive film layer on at least one side of the crystalline silicon substrate;
the main grid line electrode disposed on the metal thin layer; alternatively, the main grid line electrode disposed on the metal thin layer, and the fine grid line electrode disposed on the non-main grid region of the transparent conductive film layer where the metal thin layer is located;
optionally, the heterojunction solar cell further comprises a metal layer or an electrode layer disposed on a transparent conductive film layer without a metal thin layer;
wherein doping types of the two doped silicon layers are different.

11. The heterojunction solar cell according to claim 10, wherein the metal layer is disposed on the entire surface of the transparent conductive film layer.

12. A preparation method of a heterojunction solar cell, the method comprising the following steps of:
depositing a first intrinsic amorphous silicon layer on a front side of a crystalline silicon substrate, depositing a second intrinsic amorphous silicon layer on a back side of the crystalline silicon substrate; or depositing the first intrinsic amorphous silicon layer on the back side of the crystalline silicon substrate, depositing the second intrinsic amorphous silicon layer on the front side of the crystalline silicon substrate;
depositing a N-type amorphous silicon layer on the first intrinsic amorphous silicon layer, depositing a P-type amorphous silicon layer on the second intrinsic amorphous silicon layer;
depositing transparent conductive film layers on a surface of the N-type amorphous silicon layer and a surface of the P-type amorphous silicon layer respectively;
depositing silver thin layers on the two transparent conductive film layers respectively; and
forming main grid line electrodes on the two silver thin layers respectively by screen printing.

13. The preparation method of a heterojunction solar cell according to claim 12, wherein the step of depositing silver thin layers on the two transparent conductive film layers respectively comprises:
shielding, by using mask plates respectively, non-main grid regions on the two transparent conductive film layers; and
depositing the silver thin layers on the main grid regions on the transparent conductive film layers.

14. The preparation method of a heterojunction solar cell according to claim 12 or 13, wherein the silver thin layers are deposited by a magnetron sputtering method wherein the sputtering power is 2.5W/cm², the sputtering pressure is 0.2Pa, and the sputtering gas is argon.

15. A heterojunction solar cell, comprising:
a crystalline silicon substrate (100);
intrinsic amorphous silicon layers (200) disposed on a front side and back side of the crystalline silicon substrate (100);
a N-type amorphous silicon layer (300) disposed on an intrinsic amorphous silicon layer (200) on the front side of the crystalline silicon substrate (100);
a P-type amorphous silicon layer (400) disposed on an intrinsic amorphous silicon layer (200) on the back side of the crystalline silicon substrate (100);
transparent conductive film layers (500) disposed on the N-type amorphous silicon layer (300) and the P-type amorphous silicon layer (400);
silver thin layers (600) disposed on the two transparent conductive film layers (500) ;
main grid line electrodes (700) disposed on the two silver thin layers (600), preferably the thickness range value of the silver thin layer (600) is 10nm to 200nm.
